(19) Europäisches Patentamt
European Patent Office
Office européen des brevets

(11) **EP 4 641 241 A1**

(12) **EUROPEAN PATENT APPLICATION**

(43) Date of publication:
**29.10.2025 Bulletin 2025/44**

(21) Application number: **24171865.9**

(22) Date of filing: **23.04.2024**

(51) International Patent Classification (IPC):
***G01R 33/56*** (2006.01) ***G01R 33/485*** (2006.01)

(52) Cooperative Patent Classification (CPC):
**G01R 33/5605; G01R 33/485; G01R 33/5607; G01R 33/5608**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Koninklijke Philips N.V.**
**5656 AG Eindhoven (NL)**

(72) Inventor: **KEUPP, Jochen**
**Eindhoven (NL)**

(74) Representative: **Philips Intellectual Property & Standards**
**High Tech Campus 52**
**5656 AG Eindhoven (NL)**

(54) **MAGNETIC RESONANCE IMAGING USING CEST CONTRAST ENHANCEMENT**

(57) Methods and systems for imaging at least a part of a body are presented. The method comprises: acquiring signals by subjecting the portion of the body (10) to a chemical exchange saturation transfer, CEST, imaging protocol including radiofrequency, RF, saturation at a number of different saturation frequency offsets; generating a Z-spectrum from the acquired signals for each voxel of a set of voxels for a magnetic resonance image; using a fitting model to capture the shape of the Z-spectrum and derive a basic CEST signal for each voxel; deriving a scaling quantity based on a selected shape parameter of the fitting model, wherein the scaling quantity decreases with increasing fluid content associated to anatomical portions of the imaged part of the body; deriving a fluid-suppressed CEST contrast signal based on the basic CEST signal and the scaling quantity for each voxel; outputting the fluid-suppressed CEST contrast signal. The system comprises a computational system configured to perform the method.

(A) (B) (C) (D)

ROI "fluid"    ROI "solid"

Fig. 3

**EP 4 641 241 A1**

**Description**

**FIELD OF THE INVENTION**

The invention relates to the field of magnetic resonance imaging. It concerns a method of magnetic resonance imaging, a magnetic resonance imaging system and a computer program for a magnetic resonance imaging system.

**BACKGROUND OF THE INVENTION**

Image-forming magnetic resonance (MR) methods that utilize the interaction between magnetic fields and nuclear spins in order to form two-dimensional or three-dimensional images are widely used nowadays, notably in the field of medical diagnostics, due to their superiority for imaging soft tissue to other imaging methods, mainly because of not requiring ionizing radiation and being usually not invasive.

In some medical applications, the difference in MR signal intensity from standard magnetic resonance imaging (MRI) protocols, i.e. the contrast between different tissues, might not be sufficient to obtain satisfactory clinical information. In this case, contrast enhancing techniques are applied. A known approach for contrast enhancement and increasing of MR detection sensitivity (by orders of magnitude) is the known method based on Chemical Exchange Saturation Transfer (CEST), as initially described by Balaban et al. in US 2008/0167549 A1. With this CEST technique, the image contrast is obtained by altering the intensity of the water proton signal in the presence of a contrast agent or an endogenous molecule with a proton pool resonating at a different frequency than the main water resonance. This is achieved by selectively saturating the nuclear magnetization of the pool of exchangeable protons which resonate at a frequency different from the water proton resonance. Exchangeable protons can be provided by exogenous CEST contrast agents (e.g. DIACEST, PARACEST or LIPOCEST agents), but can also be found in biological tissue (i.e., endogenous amide protons in proteins and peptides, protons in glucose or protons in metabolites like choline or creatinine). A frequency-selective saturation RF pulse that is matched to the MR frequency of the exchangeable protons is used for this purpose. The saturation of the MR signal of the exchangeable protons is subsequently transferred to the MR signal of nearby water protons within the body of the examined patient by chemical exchange with the water protons, thereby decreasing the water proton MR signal. The selective saturation at the MR frequency of the exchangeable protons thus gives rise to a negative contrast in a proton-density weighted MR image.

Amide proton transfer weighted (APTw) MR imaging, which is a CEST technique based on endogenous exchangeable protons, allows highly sensitive and specific detection of pathological processes on a molecular level, like increased protein concentrations in malignant tumor tissue. The APT signal is also sensitively reporting on locally altered pH levels - because the exchange rate is pH dependent - which can e.g., be used to characterize ischemic stroke. APTw CEST MR imaging has several advantages over conventional MR contrasts with or without contrast agents. APTw CEST MR imaging allows highly specific detection and differentiation of exogenous and endogenous contrasts, which is much more sensitive than e.g., spectroscopic MR or NMR techniques. This high sensitivity (signal to noise ratio, SNR, efficiency) can be used to obtain molecular contrast information at a resolution comparable to typical MR imaging applications in clinically acceptable examination times.

Compared with MR signals acquired without RF saturation, the signal reductions at certain saturation frequency offsets derive not only from the CEST effect, but also from direct saturation of the water protons and, moreover, from magnetization transfer from semisolid macromolecules during in-vivo imaging. Direct saturation and also magnetization transfer can be assumed to cause signal reductions that are symmetrical with respect to the resonance frequency of water protons. In conventional CEST MR imaging, therefore, the effect of the saturation transfer of exchangeable protons to water is conventionally identified for each image voxel by an asymmetry analysis of the amplitude of the acquired MR signals as a function of the saturation frequency offset, the so-called Z-spectrum. This asymmetry analysis is performed with respect to the MR frequency of water protons, which, for convenience, is assigned to a saturation frequency offset of 0 ppm.

The measurement of the amplitude of the acquired MR signals as a function of the saturation frequency offset and the asymmetry analysis are inherently very sensitive to any inhomogeneity of the main magnetic field Bo. This is because a small shift of the center frequency (e.g., a saturation frequency offset of 0.1 ppm relative to the chemical shift of water) easily causes a variation of more than 10% in the asymmetry data. This variation results in large artifacts in the finally reconstructed CEST contrast images. It has been shown by Zhou et al., Magnetic Resonance in Medicine, 60, 842-849, 2008, that the Bo inhomogeneity can be corrected in APTw imaging on a voxel-by-voxel basis through re-centering of the Z-spectrum on the basis of a separately acquired Bo map. Asymmetry analysis for APTw imaging may be confounded by Nuclear-Overhauser exchange-relayed effects or fat contributions modifying the signal level around -3.5 ppm.

To address shortcomings of asymmetry analysis, Z-spectral fitting methods have been introduced. Here, the Z-spectral signal background (magnetization transfer, direct water saturation, etc.) may be fitted in regions not influenced by the APT effect. APTw images are then deduced from the difference of the signal to the fitted curve at +3.5ppm, often termed APT#. Background fitting is favorably used in stroke applications but can also be an essential method to remove fat signal contributions in body oncology applications by incorporating a fat signal model to the background signal model. Furthermore, background curve fitting allows to assess Nuclear Overhauser relayed exchange effects independently, for example at -3.5ppm (termed NOE#). Different types of CEST MRI contrasts of endogenous or exogenous nature may likewise be based on model fitting but use other saturation offset frequencies for CEST signal evaluation.

## SUMMARY OF THE INVENTION

An object of the invention is to provide an improved MR imaging method and an MRI system enabling CEST signal correction for compartments with significant fluid content.

In accordance with the invention, a method of MR imaging of at least a portion of a body is provided, comprising:

acquiring signals by subjecting the portion of the body to a chemical exchange saturation transfer, CEST, imaging protocol including radiofrequency, RF, saturation at a number of different saturation frequency offsets;

generating a Z-spectrum from the acquired signals for each voxel of a set of voxels for a magnetic resonance image;

using a fitting model to capture the shape of the Z-spectrum and derive a basic CEST signal for each voxel;

deriving a scaling quantity based on a selected shape parameter of the fitting model, wherein the scaling quantity decreases with increasing fluid content associated to anatomical portions of the imaged part of the body;

deriving a fluid-suppressed CEST contrast signal based on the basic CEST signal and the scaling quantity for each voxel;

outputting the fluid-suppressed CEST contrast signal.

In one embodiment the basic CEST signal is APTw CEST signal and the fluid-suppressed CEST contrast signal is fluid-suppressed APTw CEST contrast signal. While one important aim of APTw CEST MRI is to characterize malignant lesions, particularly in oncology, other tissue types may show hyperintensity in APTw CEST images and may be confounded with malignant lesions. In particular, tissue compartments with a significant fluid content and often high protein content show hyperintensity in APTw CEST images, for example, but not exclusively: cysts, hemorrhage, CSF, edema, fluid parts of necrotic tissue etc. While these compartments may typically be ruled out by using multi-parametric MRI assessment, e.g., based on joint view of T1w, T2w or FLAIR MRI contrast, it is desirable to automatically suppress the APTw CEST signal in those compartments in order to simplify and improve diagnostic reading.

By automatically suppressing the APTw CEST signal in tissue compartments with a significant fluid content and often high protein content that show hyperintensity, the APTw CEST MR imaging is significantly improved with respect to currently used state-of-the-art fluid suppression techniques, which rely on magnetization transfer levels (MTR) at the desired off-resonance $\pm \Delta\omega$, which may be influenced by many factors that vary strongly per tissue type and application. One example is the complex influence of fat signals on the level of MTR for example in body applications of APTw CEST MRI. Also, the application of spillover correction results in reduced contributions of fluid compartments but does not suppress the signal from those below the level related to actual protein concentrations. The clinical diagnosis of tissue malignancy with state-of-the-art fluid suppression techniques may still be confounded, whereas the invention provides significant improvement. The scaling parameter can be adjusted for a specific application to suppress APTw hyperintensity caused by protein-rich fluids.

The method according to the invention provides means for reliable fluid suppression without an explicit reference to the MTR level at the desired off-resonance $\Delta\omega$. It is particularly suited for APTw CEST Z-spectral processing including multi-spectral fitting. The required shape parameter is readily derived from a fit parameter, like a Lorentzian linewidth to model the direct saturation, used in the extraction of the basic APTw CEST signal and only requires a straightforward scaling operation as post-processing step. No extra measurement time and no significant post-processing time is required.

The method of the invention described thus far can be carried out by means of an MRI system including at least one main magnet coil for generating a uniform steady magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstruction of an MR image from the received MR signals. The method of the invention is preferably implemented by a corresponding programming of the control unit and/or the reconstruction unit of the MRI system.

Any of the embodiments of the method according to the invention can be advantageously carried out by a system in most MR environments in clinical use at present. To this end it is merely necessary to utilize a computer program by which a computer (e.g., a PC) comprised by the system is controlled such that it performs the above-explained method steps of the invention. The computer program may be present either on a data carrier or be present in a data network so as to be downloaded for installation, e.g., into the control unit or the reconstruction unit of an MR system.

**BRIEF DESCRIPTION OF THE DRAWINGS**

The enclosed drawings disclose preferred embodiments of the present invention. It should be understood, however, that the drawings are for the purpose of illustration only and not as a definition of the limits of the invention. In the drawings:

Fig. 1 shows an MR system according to the invention;
Fig. 2 shows a flow chart illustrating a method according to the invention;
Fig. 3 shows an example according to the invention;
Fig. 4. shows further results related to the example in Fig. 3

**DETAILED DESCRIPTION OF THE EMBODIMENTS**

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

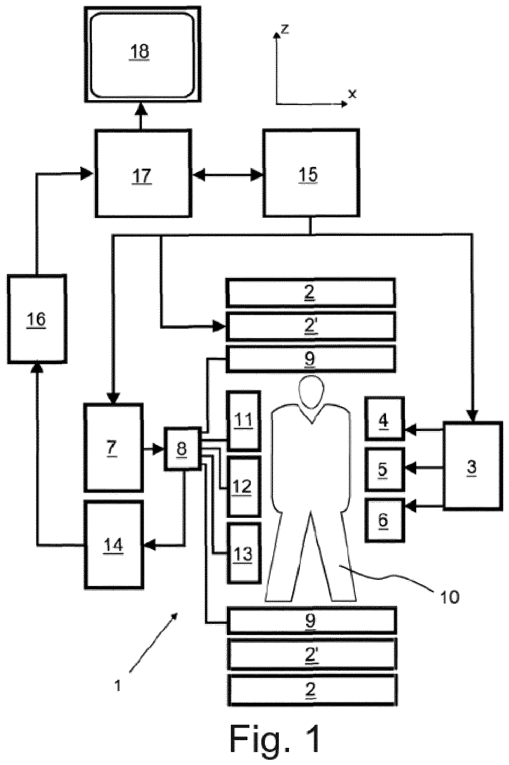

With reference to Fig. 1, an MRI system 1 is shown. The device comprises superconducting or resistive main magnet coils 2 such that a substantially uniform, temporally constant main magnetic field Bo is created along a longitudinal z-axis through an examination volume. The device further comprises a set of ($1^{st}$, $2^{nd}$, and - where applicable - $3^{rd}$ order) shimming coils 2', wherein the current flow through the individual shimming coils of the set 2' is controllable for the purpose of minimizing $B_0$ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR imaging sequence is composed of a packet of RF pulse segments which, together with any applied magnetic field gradients, achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9. The MR imaging sequences or protocols may be stored in a memory. The memory is intended to represent any combination of memory or storage device which is accessible to a computational system configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and are demodulated by a receiver 14, preferably including a preamplifier (not shown). The receiver 14 is connected to the RF coils 9, 11, 12 and 13 via send-/receive switch 8.

The RF body coil or other segmented coils, such as the local array RF coils may comprise multiple RF transmission channels. They may use a special configuration with different transmission channel settings for RF saturation and imaging RF pulses.

A computer system or with other words a host computer 15 controls the shimming coils 2' as well as the gradient pulse amplifier 3 and the transmitter 7 to generate any of a plurality of MR imaging protocols, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. The digital raw image data may be stored in the memory. In modern MR devices the data acquisition system 16 is a separate computer which is specialized in the acquisition of raw image data.

The digital raw image data is used for generating or reconstructing an image representation by a reconstruction processor 17 which applies a Fourier transform or other appropriate reconstruction algorithms, such as SENSE, GRAPPA or Compressed Sensing. Generating the MR image can be based on algorithms stored in cloud-based memory, to which the raw image data is transmitted and the cloud-based computing system may perform the image reconstruction. The MR image is then transmitted back to the MRI system. The MR image may represent a planar slice through the patient, an array of parallel planar slices, a three-dimensional volume, or the like. The MR image may then be stored in a memory where it may be accessed for converting slices, projections, or other portions of the image representation into appropriate format for visualization on a display screen for presenting the information in user-readable manner. In some embodiments the functionalities of the host computer, the data acquisition system and the reconstruction are implemented in one computer system.

Without limitation by any of the features disclosed with reference to Fig. 1, the MRI system may comprise any further elements that allow use of any of the methods disclosed in US 2013/0342207 A1, which is incorporated herein by reference in its entirety.

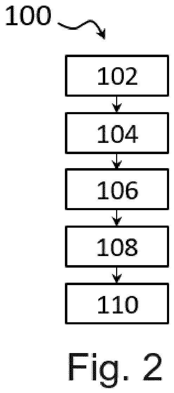

With reference to the flow chart illustrated in Fig. 2, a method 100 of deriving a fluid-suppressed APTw CEST signal according to an embodiment of the invention is explained in the following. According to step 102 a Z-spectrum is acquired with any appropriate CEST technique suitable for deriving APTw CEST, which may be based for example on any MRI protocol or sequence from e.g., 2D or 3D fast spin echo, gradient echo or echo planar imaging.

Optionally, a Bo map may be obtained, for example by using a Dixon technique, which is robust against water and fat contributions, either using the Z-spectral acquisition or at least a part of it with time to echo (TE) variation or a separate mapping scan. The acquired Z-spectrum according to step 102 may be corrected therewith for Bo shifts.

According to step 104, a fitting model is used to capture the shape of the Z-spectrum and derive the basic non fluid-suppressed APTw CEST signal, termed herein CEST#, from either a fitting parameter or the difference between the fitting and measured values at or around the desired off-resonance $\Delta\omega$.

An example of the fitting parameter to derive CEST# may be the amplitude of a Lorentzian component at the desired CEST off-resonance $\Delta\omega$, in this case included for the fitting model. In another example, the desired CEST pool is excluded from the fitting model, here a background fitting model, and the CEST# is derived from the difference between the background fitting and the measured value at $\Delta\omega$.

Without restricting the generality of possible fitting models, a typical example of a background fitting model may be:

$$S_{model}(f) = S_0 - \left( A_L \frac{w_L^2}{f^2 + w_L^2} + A_G e^{-\frac{1}{2}\left(\frac{f}{w_G}\right)^2} \right) \qquad \text{Eq. 1}$$

wherein $f$ represents the Z-spectral frequency, which may be termed saturation frequency offset, $S_0$ represents the non-saturated signal level. The direct water saturation is modelled by a Lorentzian curve of amplitude $A_L$ and width $w_L$, whereas the magnetization transfer is modelled by a Gaussian curve of amplitude $A_G$ and width $w_G$. Alternatively, the magnetization transfer may be modelled by a Super-Lorentzian curve with amplitude $A_{SL}$ and width $w_{SL}$.

The example model may be centered to the water resonance after the optional Z-spectrum correction step based on the $B_0$ map, but center frequency parameters (*e.g.*, $f_0$) can be readily included, e.g., by replacing $f$ by ($f$-$f_0$) in the right-hand side of Eq. 1.

According to step 106, a shape parameter is selected, which is used in the fitting function that is suitable for determining the water content of a given compartment.

In a preferred embodiment, the shape parameter is the linewidth $w_L$ of a Lorentzian component which models the direct water saturation (DWS) at the water resonance. In this case, a scaling quantity $q$ is derived that is less than 1.0 for fluid rich compartments to be suppressed by normalizing the linewidth with a factor $\kappa$.

The factor $\kappa$ is provided in inverse units as compared to the shape parameter, e.g., ppm$^{-1}$ for a linewidth in ppm). The scaling factor $q$ may further be tuned to adjust the strength of fluid suppression using an exponent $\varepsilon \geq 1.0$:

$$q = (\kappa \cdot w_L)^\varepsilon \qquad \text{Eq. 2}$$

Other possibilities for the shape parameter could be for example the amplitude of the Gaussian component that relates to the magnetization transfer (MT) background. Here, the water content reduces with the amplitude $A_G$, such that the scaling quantity may be defined for example to scale with the inverse $A_G^{-1}$, again possibly tuned with an exponent $\varepsilon \geq 1.0$:

$$q = (\kappa \cdot A_G^{-1})^\varepsilon \qquad \qquad \text{Eq. 3}$$

Any suitable shape parameter may be used for any type of Z-spectral model fitting function and for any basic metric providing APTw CEST signals. In some embodiments multi-pool models with multiple Lorentzian, Gaussian, Super-Lorentzian or Voigt line shapes may be used. Line modeling the signal shape around the water resonance is appropriate to derive the scaling quantity $q$ via any fit parameter related to the linewidth or the amplitude. This is because the water content or fluid content of the compartment is reflected in this component of the multi-pool model.

According to step 108, the basic non fluid-suppressed APTw CEST signal, which is denoted with *CEST#*, is scaled based on the fitting result using the quantity derived in step 106. The scaling may be restricted to downscaling only to avoid upscaling effects in solid tissues, according to:

$$CEST_{fs} = \begin{cases} q \cdot CEST\# & if\ q < 1.0 \\ CEST\# & if\ q \geq 1.0 \end{cases} \qquad \qquad \text{Eq. 4}$$

wherein $CEST_{fs}$ represents the fluid-suppressed APTw CEST signal.

Any type of APTw CEST metric, such as asymmetry, fit residuals, inverse Z-metrics, relaxation compensated metrics, may be used to measure the basic APTw CEST signal and subsequently be scaled using a scaling quantity q according to this invention.

According to step 110, the fluid-suppressed APTw CEST signal is output either to a peripheral, such as for example a screen display, or to further processing by additional for preparation of a user-intelligible information, which may comprise an image generated based on the magnetic resonance imaging of an anatomy, wherein fluid-suppressed APTw CEST results are comprised for at least a portion of the anatomy. Defining a portion of the anatomy may be performed based on segmentation of one or more anatomical regions within the magnetic resonance imaging data in response to inputting the magnetic resonance imaging data into an image segmentation algorithm comprised in the memory. The fluid-suppressed APTw CEST results may be used in addition to any contrast obtainable from the magnetic resonance imaging data, e.g., T1w, T2w, DWI, etc., or may be superimposed onto the contrast images. Fluid-suppressed APTw CEST may replace specific contrasts like, e.g., contrast-enhanced T1w MRI, and consequently, the use of exogeneous contrast agents may be reduced.

Any of the method steps may be computer-implemented such that the computer system may carry out any or all of the method steps according to any of the embodiments of the method 100 disclosed hereinbefore. The memory may comprise computer executable instructions corresponding to algorithms associated to any or all of the method steps, such that execution of the instructions causes the computer system to perform any of the method embodiments according to the invention.

The method according to the invention is presented for illustration purpose with an example. The signals were acquired by subjecting the head of a healthy person to a CEST imaging protocol, including RF saturation at a number of different saturation frequency offsets, by using a Philips Ingenia 3.0T MRI-scanner with 2-channels body-coil transmission and 20-channels head coil reception with parameters as listed below.

CEST images: 3D multi-shot fast spin-echo; TRITE = 2932/5.8 ms; FOV = 230$\times$ 201 mm$^2$; voxel size = 1.8$\times$1.8$\times$5 mm$^3$; CS-SENSE factor = 4.0; 9 slices, acquisition time 4 min 36 sec; saturation pulse power / length = 2.0 $\mu$T/800 ms; frequency offsets relative to water (46 points) =+14... -8 ppm (step 0.5 ppm) and -1560 ppm.

B$_0$ map: 3D fast field echo; TRITE = 14 /7.5 ms; FOV = 230$\times$201 mm$^2$; voxel size = 1.8$\times$1.8$\times$5 mm$^3$; CS-SENSE factor = 2.0; 9 slices, acquisition time = 45 sec.

All image data were analyzed using the software program ImageJ (version 1.47; U.S. National Institutes of Health, Bethesda, MD). A dedicated plug-in was created using Lorentzian-Gaussian background fitting (4 parameters: Lorentzian/Gaussian amplitudes $A_L/A_G$ and widths $w_L/w_G$) on 18 frequencies ($\pm$6.0, $\pm$1.22, $\pm$1.0, $\pm$0.47, 0, +7, +8...+14 ppm) after interpolation-based B$_0$ correction to assess *CEST#* as fit residuals at $\Delta\omega$ =+3.5 ppm. The proposed method was performed according to Eq. 1, Eq. 2 and Eq. 4, using $\kappa$=(1.9 ppm)$^{-1}$ and $\varepsilon$=1.0.

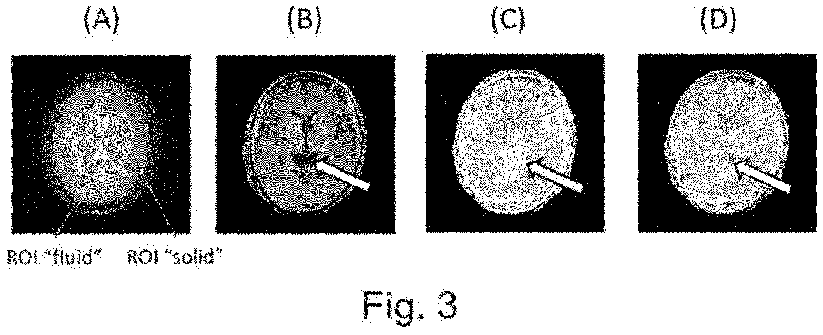

Figure 3 shows brain imaging results of the healthy person. In Fig. 3 (A) the $S_0$ anatomical brain image is shown, the arrows indicating two chosen regions of interest, one for fluid rich region denoted ROI "fluid" and one for solid tissue denoted ROI "solid", respectively.

Figure 3 (B) shows a map of the scaling parameter $q$ according to Eq. 2, which shows low values (<<1.0) in fluid rich areas containing CSF, like the ventricles, indicated by the arrow.

Figure 3 (C) shows a basic *CEST#* map, here derived from the residual of the background fit according to Eq. 1 and the data recorded at $\Delta\omega$ = +3.5 ppm, with other words the derived from a Z-spectral fit using the difference of the measured signal at $\Delta\omega$ = +3.5 ppm and the Lorentz-Gauss background fit.

Figure 3 (D) shows the resulting fluid-suppressed $CEST_{fs}$ map according to Eq. 4, with lowered signal contributions from fluid rich areas, as desired for improved and simplified diagnostic reading.

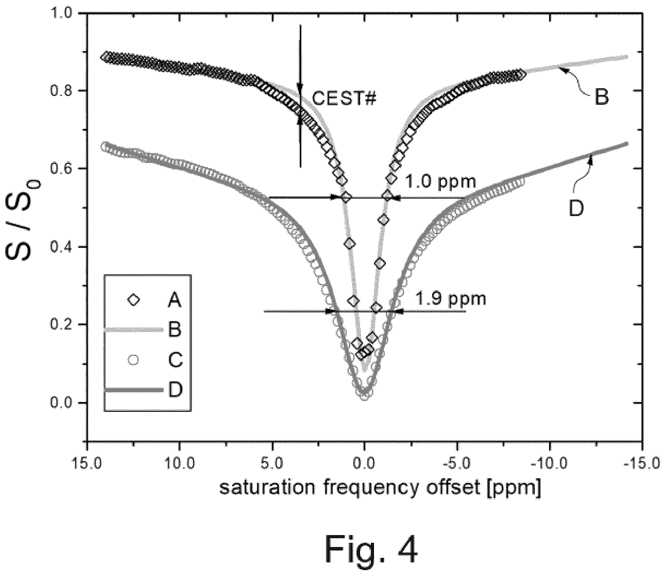

With reference to Fig. 4, fluid rich compartments show a Lorentzian linewidth of about 1.0 ppm (ROI "fluid"; Z-spectral data denoted A, model fit denoted B), while solid tissues show a significantly broader linewidth of about 2.0 ppm (Fig. 4: ROI "solid"; Z-spectral data denoted C, model fit denoted D). The Lorentzian linewidth fit parameter $w_L$ in the fluid rich area leads to a scaling factor $q$ = 0.53 according to Eq. 2, with $\kappa$ = (1.9 ppm)$^{-1}$ and $\varepsilon$ = 1.0. Accordingly, the APTw CEST contrast is downscaled in the fluid area as required, according to $CEST_{fs}$ = $q \cdot CEST\#$ conform Eq. 4, when $q$ < 1.0. The linewidth in the example solid area leads to $q$ = 1.05, such that the $CEST_{fs}$ remains unchanged relative to $CEST\#$ according to Eq. 4.

In any of the embodiments the desired off-resonance frequency for CEST imaging may relate to any of the following entities (exchangeable pools): Amide (-NH), Hydroxyl (-OH), Amine (-NH$_2$), Imino-groups (=NH, double bound), exchange-relayed NOE, intra-liposomal water and bound water of molecules (complexes). These entities are involved in chemical exchange via proton exchange, molecular exchange, or compartmental exchange.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

**Claims**

1. A method of imaging at least a part of a body (10), comprising:

   acquiring signals by subjecting the portion of the body (10) to a chemical exchange saturation transfer, CEST, imaging protocol including radiofrequency, RF, saturation at a number of different saturation frequency offsets;
   generating a Z-spectrum from the acquired signals for each voxel of a set of voxels for a magnetic resonance image;
   using a fitting model to capture the shape of the Z-spectrum and derive a basic CEST signal for each voxel;
   deriving a scaling quantity based on a selected shape parameter of the fitting model, wherein the scaling quantity decreases with increasing fluid content associated to anatomical portions of the imaged part of the body;
   deriving a fluid-suppressed CEST contrast signal based on the basic CEST signal and the scaling quantity for each voxel;
   outputting the fluid-suppressed CEST contrast signal.

2. The method of claim 1, wherein the basic CEST signal is APTw CEST signal.

3. The method of claim 1 or 2, wherein the basic CEST signal is derived from either a fitting parameter or from the difference between the fitting model and measured values at and in the vicinity of at least one selected off-resonance frequency.

4. The method of any of the preceding claims, wherein for the fitting model the contribution from direct water saturation is modelled by a Lorentzian curve of amplitude $A_L$ and width $w_L$.

5. The method of any of the preceding claims, wherein for the fitting model the contribution from magnetization transfer is modelled by a Gaussian curve of amplitude $A_G$ and width $w_G$.

6. The method of any of the claims 1 to 4, wherein for the fitting model the contribution from magnetization transfer is modelled by a Super-Lorentzian curve with amplitude $A_{SL}$ and width $w_{SL}$.

7. The method of claim 5, wherein the shape parameter is width $w_L$ or amplitude $A_G$.

8. The method of claim 6, wherein the shape parameter is width $w_L$ or amplitude $A_{SL}$.

9. The method of any of the preceding claims, further comprising:

obtaining a $B_0$ map; and
applying a saturation frequency offset correction to the generated Z-spectra according to the Bo map.

10. The method of claim 9, wherein the $B_0$ map is obtained from the acquired signals by means of a single-point or multi-point Dixon technique.

11. The method of any of the preceding claims, wherein for generating the Z-spectrum the number of points of the acquired signals is less than 50, preferably less than 20.

12. The method of any of the claims 3 to 11, wherein the off-resonance frequency for CEST imaging relates to any of the following entities (exchangeable pools): Amide (-NH), Hydroxyl (-OH), Amine (-NH$_2$), Imino-groups (=NH, double bound), exchange-relayed NOE, intra-liposomal water and bound water of molecules (complexes).

13. A system for imaging at least a part of a body, comprising a computational system configured to perform a method according to any of the claims 1 to 12.

14. The system of claim 13, further comprising:

a magnetic resonance imaging system for acquiring signals by subjecting the portion of the body to the CEST imaging protocol;
a display screen configured to display the information output by the computational system.

15. A computer program comprising machine executable instructions, wherein execution of the machine executable instructions causes a computational system to perform a method according to any of the claims 1 to 12.

EP 4 641 241 A1

Fig. 1

100

102

104

106

108

110

Fig. 2

Fig. 3

Fig. 4

Europäisches
Patentamt

European
Patent Office

Office européen
des brevets

# EUROPEAN SEARCH REPORT

**Application Number**

EP 24 17 1865

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JAN-RÜDIGER SCHÜRE ET AL: "Fluid suppression in amide proton transfer-weighted (APTw) CEST imaging: New theoretical insights and clinical benefits", MAGNETIC RESONANCE IN MEDICINE, WILEY-LISS, US, vol. 91, no. 4, 10 December 2023 (2023-12-10), pages 1354-1367, XP072580331, ISSN: 0740-3194, DOI: 10.1002/MRM.29915 * section "2 ¦ THEORY" * * section "3 ¦ METHODS" * | 1-15 | INV. G01R33/56 G01R33/485 |
| A | STEFANO CASAGRANDA ET AL.: "Fluid suppression in CEST imaging affects predominantly IDH-mutant 1p/19q retained gliomas with T2-FLAIR mismatch", PROCEEDINGS OF THE ISMRM & SMRT VIRTUAL CONFERENCE & EXHIBITION, 08-14 AUGUST 2020, no. 500, 24 July 2020 (2020-07-24), XP040714415, * the whole document * | 1-15 | |
| | | | **TECHNICAL FIELDS SEARCHED (IPC)** G01R |
| A | JOCHEN KEUPP ET AL.: "Magnetization Transfer Ratio based Metric for APTw or CESTw MRI Suppressing Signal from Fluid Compartments - Initial Application to Glioblastoma Assessment", PROCEEDINGS OF THE INTERNATIONAL SOCIETY FOR MAGNETIC RESONANCE IN MEDICINE, ISMRM, JOINT ANNUAL MEETING ISMRM-ESMRMB, PARIS, FRANCE, 16-21 JUNE 2018, no. 3156, 1 June 2018 (2018-06-01), XP040702364, * the whole document * | 1-15 | |

-/--

The present search report has been drawn up for all claims

| Place of search | Date of completion of the search | Examiner |
|---|---|---|
| Munich | 4 October 2024 | Durst, Markus |

EPO FORM 1503 03.82 (P04C01)

page 1 of 2

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/063519 A1 (KEUPP JOCHEN [NL]) 4 March 2021 (2021-03-04) * figures 3,4,5 * * paragraph [0061] - paragraph [0083] * ----- | 1-15 | |

| | | | **TECHNICAL FIELDS SEARCHED (IPC)** |
|---|---|---|---|

The present search report has been drawn up for all claims

| Place of search | Date of completion of the search | Examiner |
|---|---|---|
| Munich | 4 October 2024 | Durst, Markus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...........................................................................................
& : member of the same patent family, corresponding
    document

EPO FORM 1503 03.82 (P04C01)

EP 4 641 241 A1

## ANNEX TO THE EUROPEAN SEARCH REPORT
## ON EUROPEAN PATENT APPLICATION NO.

EP 24 17 1865

04-10-2024

| Patent document cited in search report | Publication date | Patent family member(s) | Publication date |
|---|---|---|---|
| US 2021063519 A1 | 04-03-2021 | CN 111566497 A | 21-08-2020 |
| | | EP 3511729 A1 | 17-07-2019 |
| | | EP 3737957 A1 | 18-11-2020 |
| | | JP 2021510567 A | 30-04-2021 |
| | | US 2021063519 A1 | 04-03-2021 |
| | | WO 2019137837 A1 | 18-07-2019 |

EPO FORM P0459

**REFERENCES CITED IN THE DESCRIPTION**

**Patent documents cited in the description**

- US 20080167549 A1
- US 20130342207 A1

**Non-patent literature cited in the description**

- **ZHOU et al.** *Magnetic Resonance in Medicine*, 2008, vol. 60, 842-849